# EUROPEAN PATENT APPLICATION

(11) **EP 4 290 996 A1**
(43) Date of publication of application: **13.12.2023**
(21) Application number: 21924563.6
(22) Date of filing: 02.02.2021
(51) Int. Cl.: H05K 13/00, H05K 13/02

(54) **MOUNTING SYSTEM**

(71) Applicant: Fuji Corporation, Chiryu-shi, Aichi 472-8686 (JP)
(72) Inventor: OYAMA, Shigeto, Chiryu-shi, Aichi 472-8686 (JP)
(74) Representative: Grünecker Patent- und Rechtsanwälte PartG mbB
(86) International application number: PCT/JP2021/003739
(87) International publication number: WO 2022/168166

(57) **Abstract**

A mounting system including multiple mounting lines in which multiple mounting-related devices configured to perform a mounting-related process related to mounting a component are arranged side by side, in which a member used in the mounting-related process is conveyed to a predetermined portion in the mounting line by an automatic conveyance vehicle includes a creation section configured to create a travel plan of the automatic conveyance vehicle based on a production plan of the multiple mounting lines, and a control section configured to control traveling of the automatic conveyance vehicle to the predetermined portion based on the travel plan.

## Description

### Technical Field

The present description discloses a mounting system.

### Background Art

Conventionally, there has been known a mounting system including multiple mounting lines in which a mounting-related facility such as a mounter that mounts a component on a board is arranged side by side, in which a member and the like used for mounting is automatically conveyed to the mounting line by an automatic conveyance vehicle (automatic conveyance apparatus) (see Patent Literature 1, for example). In this mounting system, a conveyance plan creation section calculates the remaining number of components based on production planning data and production actual number data, and creates a conveyance plan for an accommodation member of the component based on the remaining number.

### Patent Literature

Patent Literature 1: JP-A-2019-091770

### Summary of the Invention

### Technical Problem

In the mounting system described above, since the conveyance plan of the accommodation member of the component is created based on the remaining number of components, the production plan of the mounting line to be conveyed is considered, but the production plan of the other mounting lines is not considered. For this reason, when the automatic conveyance vehicle starts traveling in a case where work such as a setup change is performed on a mounting line adjacent to the mounting line which is a conveyance destination, for example, it is necessary to cause the automatic conveyance vehicle to stand by on the way to prevent interference with the work, so that the conveyance efficiency of the member by the automatic conveyance vehicle decreases.

It is a main object of the present disclosure to travel an automatic conveyance vehicle efficiently by appropriately performing a travel control of the automatic conveyance vehicle that automatically conveys a member.

### Solution to Problem

The present disclosure employs the following means in order to achieve the above-described main object.

A mounting system of the present disclosure including multiple mounting lines in which multiple mounting-related devices configured to perform a mounting-related process related to mounting a component are arranged side by side, the mounting system in which a member used in the mounting-related process is conveyed to a predetermined portion in the mounting line by an automatic conveyance vehicle, the mounting system includes a creation section configured to create a travel plan of the automatic conveyance vehicle based on a production plan of the multiple mounting lines, and a control section configured to control traveling of the automatic conveyance vehicle to the predetermined portion based on the travel plan.

The mounting system of the present disclosure creates the travel plan of the automatic conveyance vehicle based on the production plan of the multiple mounting lines, and controls the traveling of the automatic conveyance vehicle to a predetermined portion based on the travel plan. As a result, since the automatic conveyance vehicle can be traveled in an appropriate state according to the production plan of the multiple mounting lines, it is possible to suppress the automatic conveyance vehicle from interfering with various kinds of work, the mounting-related process, and the like performed on each mounting line, or causing the automatic conveyance vehicle to stand by for a long time during traveling for the interference prevention. Accordingly, it is possible to travel an automatic conveyance vehicle efficiently by appropriately performing a travel control of the automatic conveyance vehicle that automatically conveys a member.

### Brief Description of Drawings

Fig. 1 is an explanatory diagram illustrating an example of mounting system 1.
Fig. 2 is an explanatory diagram schematically illustrating a configuration of mounting line 10.
Fig. 3 is an explanatory diagram schematically illustrating a configuration of mounter 20.
Fig. 4 is a block diagram illustrating a configuration related to control of mounting system 1.
Fig. 5 is a flowchart illustrating an example of a travel plan creation processing.
Fig. 6 is an explanatory diagram illustrating an example of travel plan TP created from production plan PP.
Fig. 7 is a flowchart illustrating an example of an AGV travel control.
Fig. 8 is an explanatory diagram illustrating an example of a state in which AGV 55 travels to storage chamber 16.
Fig. 9 is a flowchart illustrating an AGV travel control according to a modification example.

### Description of Embodiments

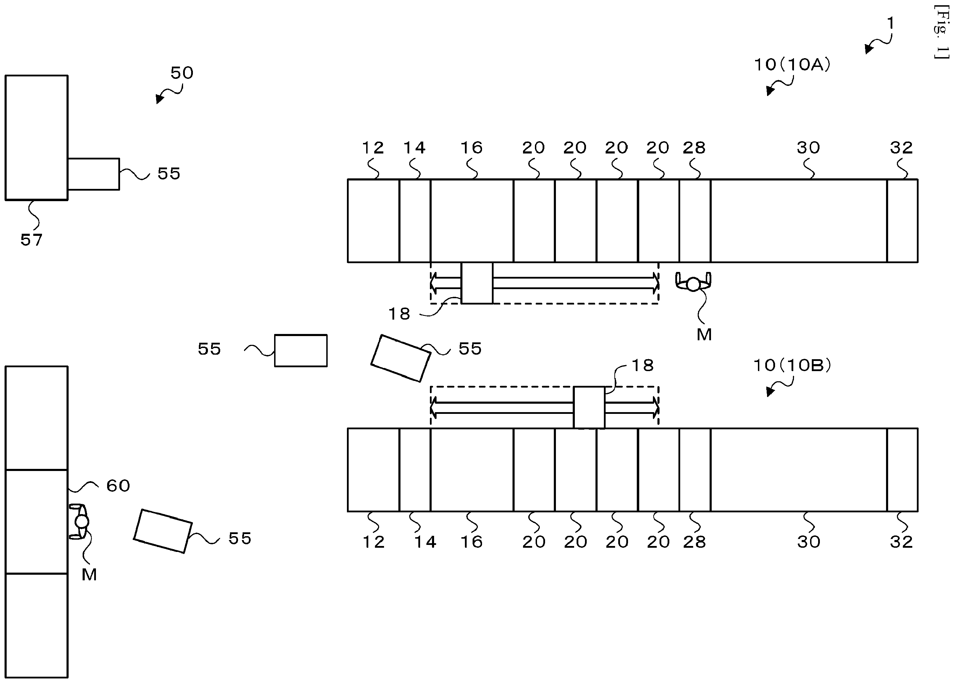

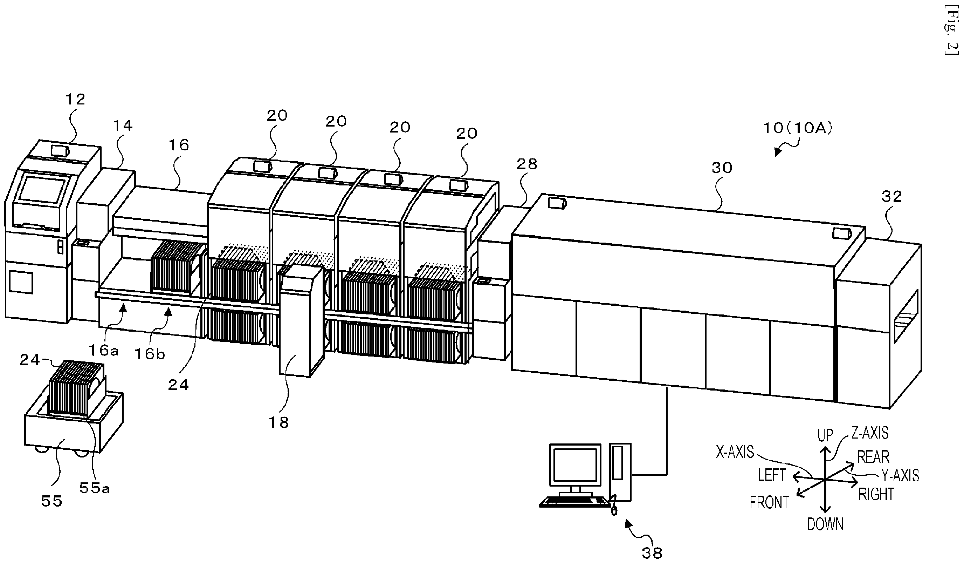

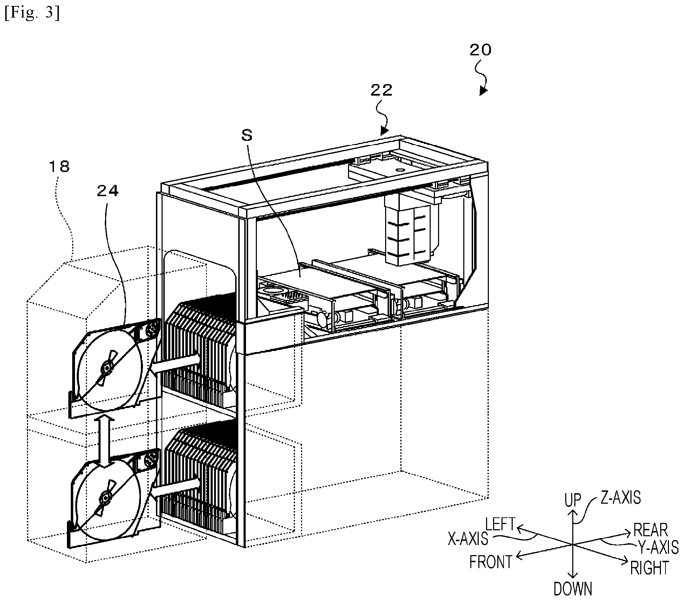

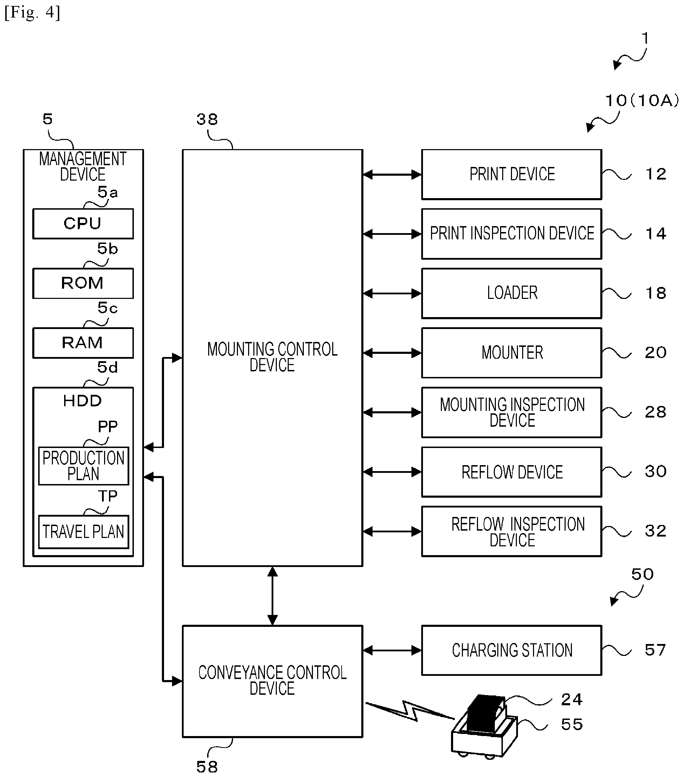

Next, embodiments of the present disclosure will be described with reference to the drawings. Fig. 1 is an explanatory diagram illustrating an example of mounting system 1. Fig. 2 is an explanatory diagram schematically illustrating a configuration of mounting line 10. Fig. 3 is an explanatory diagram schematically illustrating a configuration of mounter 20. Fig. 4 is a block diagram illustrating a configuration related to control of mounting system 1. In the present embodiment, a left-right direction (X-axis), a front-rear direction (Y-axis), and an up-down direction (Z-axis) are as illustrated in Figs. 2 and 3.

Mounting system 1 includes multiple mounting lines 10 (10A and 10B) (two are exemplified in Fig. 1) in which a mounting-related process related to mounting a component on board S is performed, and a conveyance process of various members used in the mounting-related process is performed by conveyance system 50. Mounting system 1 includes management device 5 that manages all processes of the system. Each mounting line 10 includes multiple mounting-related devices that perform the mounting-related process, and mounting control device 38 that controls the multiple mounting-related devices. Further, conveyance system 50 includes multiple automatic conveyance vehicles 55 (hereinafter, referred to as AGVs 55), charging station 57, and conveyance control device 58.

The multiple mounting-related devices of mounting line 10 include, for example, one or more of print device 12, print inspection device 14, storage chamber 16, mounter 20, mounting inspection device 28, reflow device 30, reflow inspection device 32, and the like. These are arranged side by side along a conveyance direction (X-axis direction) of board S. In addition, in the present embodiment, loader 18 movable along mounting line 10 is provided. Each mounting line 10 (10A and 10B) has the same configuration, but may have a different configuration, and only one mounting line 10 (10A) is illustrated in Figs. 2 and 4.

Print device 12 performs printing on board S (see Fig. 3) by pushing solder into pattern holes formed in a screen mask. Print inspection device 14 inspects a state of the solder printed by print device 12. Mounting inspection device 28 inspects a mounting state of a component mounted on board S by mounter 20. Reflow device 30 melts the solder by heating board S on which the component is disposed on the solder and then cools the solder, and thereby, the component is electrically connected to board S to be fixed to board S. Reflow inspection device 32 inspects a state of the component on board S after reflow.

Multiple mounters 20 are disposed in the conveyance direction of board S and mount components on board S. As illustrated in Fig. 3, mounter 20 includes mounting unit 22 and feeder 24. Mounting unit 22 is a unit for collecting components and mounting the components on board S by using a mounting head on which a collection member such as a nozzle is mounted. Feeder 24 is configured as a tape feeder to which a reel on which a tape holding a component in a predetermined pitch is wound is detachably attached and which feeds the tape to supply the component by rotating the reel.

Loader 18 is configured to be movable in a movement area along the conveyance direction of board S (an area indicated by dashed lines in Fig. 1) on a front surface side of multiple mounters 20 and storage chamber 16. Loader 18 moves in the movement area to perform automatic exchange work that automatically exchanges (retrieves or replenishes) members used in a mounting process. For example, loader 18 automatically exchanges feeder 24, which is a work unit that can be exchanged for mounter 20, but may automatically exchange members used in the mounting-related process, such as a collection member such as a head and a nozzle, an accommodation member for solder, and a screen mask, which are provided in mounting unit 22.

Storage chamber 16 is an in-line storage for storing various members used in the mounting-related process in each mounting line 10, and stores, for example, feeder 24. In storage chamber 16, worker M can supply (replenish) and retrieve feeder 24. Further, loader 18 is capable of automatically exchanging feeder 24 for storage chamber 16, taking out necessary feeder 24 from storage chamber 16 to replenish feeder 24 to mounter 20, or taking out used feeder 24 from mounter 20 to retrieve in storage chamber 16. Further, in storage chamber 16, AGV 55 can also replenish or retrieve feeder 24. In addition, storage chamber 16 is defined by multiple storage sections such as first storage section 16a and second storage section 16b, for example, so that feeder 24 can be stored in each storage section.

Mounting control device 38 is a general-purpose computer including CPU, ROM, RAM, HDD, and the like, and is connected to an input device such as a keyboard and a mouse and an output device such as a display. Storage device such as the HDD of mounting control device 38 stores a production plan of board S (production plan PP to be described later) and production information related to production of board S. The production plan defines a mounting order of components on board S, the production number of boards S, and the like. Further, the production information includes information indicating a printing position of solder on board S, information of a component to be mounted on board S, a mounting position of each component, and the like. The information of a component indicates not only the type of component to be mounted on each mounter 20, but also an arrangement state of feeder 24 in each mounter 20 and storage chamber 16 as an inventory status of components. When producing board S, mounting control device 38 provides various command signals to print device 12, print inspection device 14, loader 18, mounter 20, mounting inspection device 28, reflow device 30, reflow inspection device 32, and the like based on the production plan and the production information. In addition, mounting control device 38 is communicably connected to conveyance control device 58, and exchanges information on a work state of loader 18, information on a traveling state of AGV 55, and the like.

Although not illustrated, AGV 55 includes a motor for rotationally driving wheels, a battery for supplying electric power, and the like, and automatically conveys members, such as feeder 24, used in the mounting-related process between warehouse 60 and storage chamber 16. For example, AGV 55 takes out necessary feeder 24 from warehouse 60 and automatically conveys feeder 24 to storage chamber 16 to be served (supplied) therein, or retrieves used feeder 24 from storage chamber 16 and automatically conveys used feeder 24 to warehouse 60 to be accommodated therein. Although AGV 55 automatically conveys feeder 24, AGV 55 may automatically convey members used in the mounting-related process, such as a collection member such as a head and a nozzle, an accommodation member for solder, and a screen mask, which are provided in mounting unit 22.

Here, for example, automatic exchange with whole magazine 55a can be made at once between AGV 55 and storage chamber 16 in a state in which multiple feeders 24 are loaded in magazine 55a as a predetermined load member. In a state in which first one of the above-mentioned first storage section 16a and second storage section 16b in storage chamber 16 is empty, loader 18 takes in and out feeders 24 from second one thereof and retrieves used feeders 24 to the second one thereof. In a case where the serving and the retrieval of feeders 24 are performed, AGV 55 first drives off multiple feeders 24 to be served with whole magazine 55a and serves the same to one storage section of first storage section 16a and second storage section 16b in storage chamber 16. Next, AGV 55 receives and retrieves multiple feeders 24 with whole magazine 55a retrieved in the second one of first storage section 16a and second storage section 16b. AGV 55 automatically conveys retrieved feeders 24 to warehouse 60.

Warehouse 60 stores various members such as feeders 24 accommodated by worker M and feeders 24 automatically conveyed by AGV 55. AGV 55 can take in and out multiple feeders 24 with whole magazine 55a at once from warehouse 60. Charging station 57 is a facility for charging a battery of one or more AGVs 55 parked in a predetermined charging position. When AGV 55 is parked in a predetermined charging position, charging station 57 may have a configuration in which a connector is connected to enable power supply or may have a configuration in which power supply is enabled without contact.

Conveyance control device 58 is a general-purpose computer including CPU, ROM, RAM, HDD, and the like, and is connected to an input device such as a keyboard or a mouse and an output device such as a display. Conveyance control device 58 is configured to be communicably connected to AGV 55 by wireless, and acquires position information of AGV 55, performs a travel control such as departure and standby of AGV 55, and acquires a state such as a remaining charge of battery of AGV 55, and the like. Further, conveyance control device 58 also performs a charging control or the like of AGV 55 in charging station 57.

Management device 5 is a general-purpose computer including CPU 5a, ROM 5b, RAM 5c, HDD 5d, and the like, and is connected to an input device such as a keyboard or a mouse, and an output device such as a display. Management device 5 is configured to communicate with each mounting control device 38 and conveyance control device 58 of each mounting line 10. Management device 5 stores production plan PP of board S, travel plan (conveyance plan) TP of AGV 55, and the like in HDD 5d. Management device 5 transmits production plan PP and the production information of board S of each mounting line 10 to each mounting control device 38. Management device 5 receives a production state of board S, a use state of feeder 24 necessary for production, the arrangement state of feeder 24 in storage chamber 16, and the like from each mounting control device 38. The production state includes the state of setup change which performs an exchange of a screen mask, an exchange of feeder 24, or the like as a production preparation for different types of boards. In addition, management device 5 transmits travel plan TP of each AGV 55 to conveyance control device 58, or receives the traveling state, the remaining charge of battery, the charging state, and the like of each AGV 55 from conveyance control device 58. Management device 5 creates travel plan TP including a conveyance schedule, a charging schedule, and the like of feeder 24 in each AGV 55 based on production plan PP of board S and the production state of board S in each mounting line 10, information relating feeder 24 necessary for production, and the like.

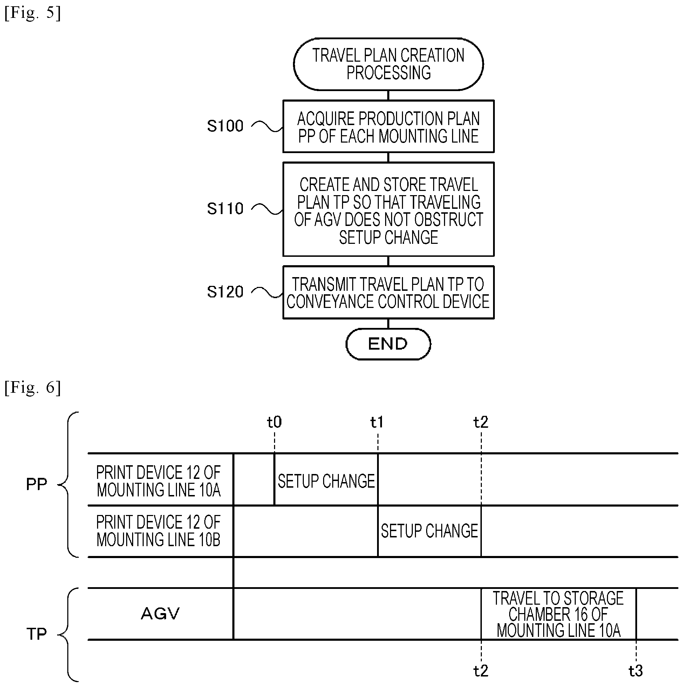

The operation of mounting system 1 configured as described above, in particular, a process related to the traveling of AGV 55 will be described. First, travel plan TP of AGV 55 will be described. Fig. 5 is a flowchart illustrating an example of a travel plan creation processing.

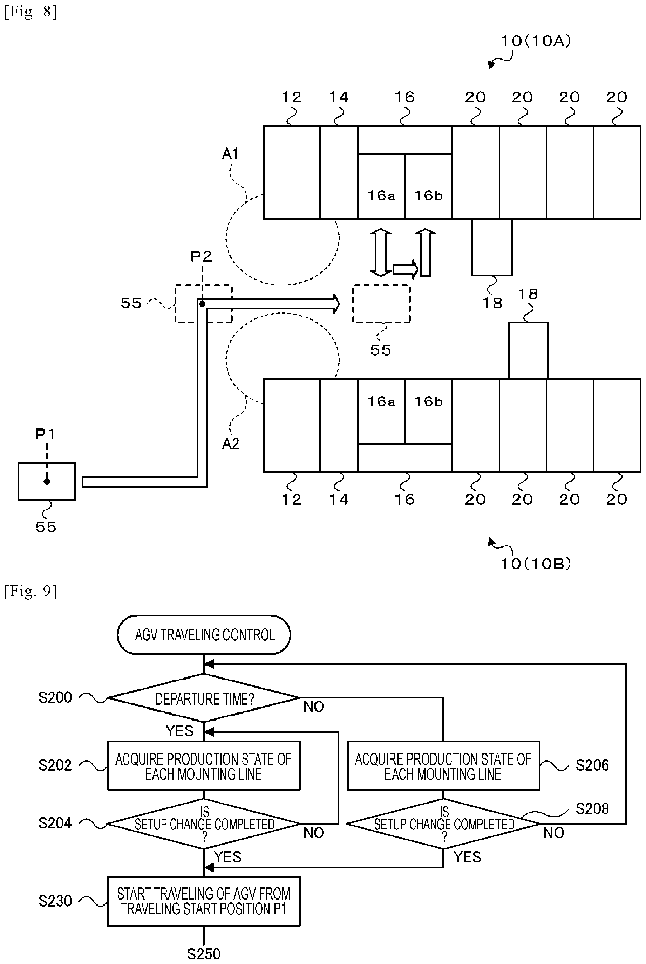

In the travel plan creation processing illustrated in Fig. 5, CPU 5a of management device 5 first acquires production plan PP of each of mounting lines 10A and 10B (S100). Next, based on the schedule of the setup change in the acquired production plan PP, CPU 5a creates travel plan TP of AGV 55 and stores travel plan TP in HDD 5d so that the traveling of AGV 55 does not obstruct the setup change (S 110). For example, in a case where traveling AGV 55 interferes with a work area for the setup change (see work areas A1 and A2 in Fig. 8 to be described later), the traveling of AGV 55 may be an obstruction of the setup change, such as requiring the worker to interrupt the setup change to prevent contact with AGV 55. For this reason, conveyance control device 58 creates travel plan PP so as not to cause such an interruption of the setup change. In addition, in S 110, travel plan TP may be created so that the traveling of AGV 55 is not obstructed by the setup change, for example, so that the standby of AGV 55 is not required in order to wait for the interruption or the end of the setup change. Subsequently, CPU 5a of management device 5 transmits travel plan TP to conveyance control device 58 of conveyance system 50 (S120), and ends the travel plan creation processing.

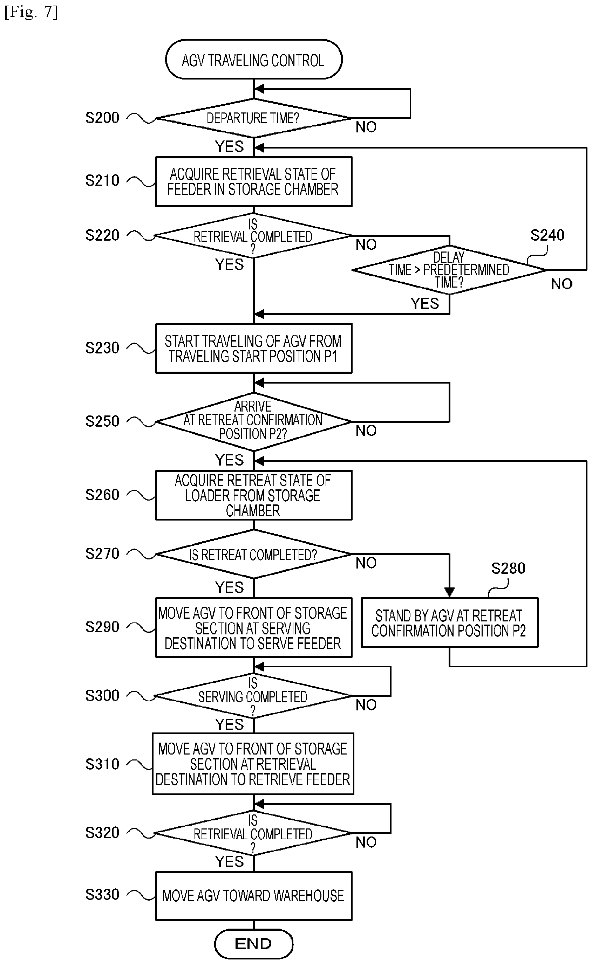

Fig. 6 is an explanatory diagram illustrating an example of travel plan TP created from production plan PP. In production plan PP of Fig. 6, as an example, a setup change of print device 12 of mounting line 10A is scheduled to be performed from time t0 to time t1, and a setup change of print device 12 of mounting line 10B is scheduled to be performed from time t1 to time t2. In travel plan TP in Fig. 6, after the setup change is ended, that is, from time t2 when the traveling of AGV 55 does not obstruct the setup change, AGV 55 is scheduled to travel to storage chamber 16 of mounting line 10A. Therefore, since AGV 55 does not need to stand by during traveling by the setup change, the traveling of AGV 55 is not obstructed by the setup change. In Fig. 6, AGV 55 is scheduled to start traveling after the setup change is ended; however, the configuration is not limited to this. For example, in a case where there are multiple paths that can be traveled to storage chamber 16 of mounting line 10A, CPU 5a of management device 5 may search for a path that does not obstruct the setup change, and may select the path if there is a path that does not obstruct the setup change even if it is not shortest path. Then, from time before time t2 (the setup change is ended), AGV 55 may be scheduled to start traveling on the selected path. Fig. 6 exemplifies a setup change of print device 12; however the configuration is not limited to this, and a setup change of mounter 20 may be exemplified. In addition, the work of AGV 55 in storage chamber 16 and the return of AGV 55 to warehouse 60 will be completed at time t3. Conveyance control device 58 stores received travel plan TP in HDD or the like, and controls the traveling of AGV 55 based on travel plan TP. Fig. 7 is a flowchart illustrating an example of an AGV travel control, and Fig. 8 is an explanatory diagram illustrating an example of a state in which AGV 55 travels to storage chamber 16.

In the AGV travel control in Fig. 7, conveyance control device 58 waits for the departure time to be reached, which is determined by travel plan TP (S200). In S200, for example, conveyance control device 58 waits until time t2 of travel plan TP illustrated in Fig. 6. In the present embodiment, it is assumed that the departure preparation, such as loading all feeders 24 to be served on AGV 55, is completed by the departure time, for example.

When the departure time of travel plan TP is reached, conveyance control device 58 acquires a retrieval state of feeders 24 in storage chamber 16 at the destination by communication with mounting control device 38 (S210), and determines whether the retrieval of feeders 24 is completed (S220). When it is determined that the retrieval of feeders 24 is completed, that is, feeders 24 to be retrieved are prepared in storage chamber 16, conveyance control device 58 starts the traveling of AGV 55 from a predetermined traveling start position P1 (see to Fig. 8) (S230).

On the other hand, when it is determined that the retrieval of feeders 24 is not completed, conveyance control device 58 determines whether the delay time from the scheduled departure time exceeds a predetermined time without proceeding to the process of S230 (S240). That is, when the retrieval of feeders 24 is not completed even when the departure time is reached, conveyance control device 58 causes AGV 55 to stand by without starting the traveling of AGV 55, and waits for the retrieval to be completed while determining whether the delay time from the departure time exceeds a predetermined time. When it is determined that the retrieval of feeders 24 is completed without the delay time exceeding a predetermined time, conveyance control device 58 starts the traveling of AGV 55 in S230. In addition, when it is determined that the delay time is exceeded a predetermined time in S240 before the retrieval of feeders 24 is completed, conveyance control device 58 starts the traveling of AGV 55 in S230. That is, in a case where the delay time exceeds a predetermined time and a delay increases, conveyance control device 58 starts the traveling of AGV 55 even if feeders 24 to be retrieved are not prepared.

When the traveling of AGV 55 is started in this manner, conveyance control device 58 waits for AGV 55 to arrive at retreat confirmation position P2 (see to Fig. 8) based on the position information of AGV 55 (S250). Retreat confirmation position P2 is determined to be positioned in front of storage chamber 16 which is the destination, and be a position that does not interfere with the work or the movement of loader 18 even if AGV 55 stands by. When it is determined that AGV 55 arrives at retreat confirmation position P2, conveyance control device 58 acquires a retreat state of loader 18 from in front of storage chamber 16 by communication with mounting control device 38 (S260). Next, when it is determined whether the retreat of loader 18 is completed based on the retreat state (S270), and when it is determined that the retreat is not completed, conveyance control device 58 waits for the retreat of loader 18 to be completed in S260 and S270 while causing AGV 55 to stand by at retreat confirmation position P2 (S280). It is assumed that the fact that AGV 55 started traveling is notified from management device 5 or conveyance control device 58 to mounting control device 38. Upon receiving the notification, mounting control device 38 causes loader 18 to be retracted from in front of storage chamber 16 by completing the work of loader 18 in storage chamber 16 or temporarily interrupting the work of loader 18. Therefore, generally, when AGV 55 arrives at retreat confirmation position P2, since loader 18 has been retracted or is being retracted, the waiting time hardly becomes a long time even if AGV 55 is caused to stand by at retreat confirmation position P2.

When it is determined that the retreat of loader 18 is completed in S270, conveyance control device 58 moves AGV 55 in front of a storage section (for example, first storage section 16a in Fig. 8) at the serving destination to execute the serving work of feeders 24 (S290), and waits for the serving work to be completed (S300). Next, when it is determined that the serving work of feeders 24 is completed, conveyance control device 58 moves AGV 55 in front of the second one of storage sections (for example, second storage section 16b in Fig. 8) at the retrieval destination to execute the retrieval work of feeders 24 (S310), and waits for the retrieval work to be completed (S320). When it is determined that the retrieval work of feeders 24 is completed, conveyance control device 58 starts the movement of AGV 55 with warehouse 60 as the destination (S330), and ends the AGV travel control. The travel control of AGV 55 to warehouse 60 is not intended to be a gist of the present invention, and thus the description thereof will be omitted. When AGV 55 starts to move, conveyance control device 58 transmits a work completion notification to mounting control device 38. Mounting control device 38 that has received the work completion notification allows loader 18 to be moved to storage chamber 16 and to be worked. In addition, in a case where AGV 55 starts traveling in S230 because the delay time is exceeded a predetermined time in S240, AGV 55 may retrieve feeders 24 in a state in which feeders 24 are not prepared in the storage section at the retrieval destination in S310. In that case, management device 5 creates travel plan TP again in which the retrieval schedule of feeders 24 is added in order to cause AGV 55 to retrieve feeders 24 again that could not be retrieved.

Here, a correspondence between elements of the present embodiment and elements of the present disclosure will be clarified. Mounting line 10 (10A and 10B) of the present embodiment corresponds to a mounting line, management device 5 corresponds to a creation section, AGV 55 corresponds to an automatic conveyance vehicle, and conveyance control device 58 corresponds to a control section.

In mounting system 1 described above, travel plan TP of the AGV is created based on production plan PP of multiple mounting lines 10, and the traveling of AGV 55 to storage chamber 16 is controlled based on travel plan TP. Therefore, since AGV 55 can be traveled in an appropriate state according to production plan PP of multiple mounting lines 10, it is possible to suppress AGV 55 from interfering with various kinds of work, the mounting-related process, and the like performed on each mounting line 10, or the occurrence of a waiting time for AGV 55 to prevent the interference. Accordingly, it is possible to convey feeder 24 (member) efficiently by AGV 55 by appropriately performing the travel control of AGV 55.

In addition, based on the schedule of the setup change of production plan PP, travel plan TP is created so that the traveling of AGV 55 does not obstruct the setup change, or so that the traveling of AGV 55 is not obstructed by the setup change. Therefore, it is possible to suppress the occurrence of a delay in the setup change or the occurrence of a waiting time for AGV 55.

In addition, since the traveling of AGV 55 is started after the departure time determined by travel plan TP, it is possible to prevent AGV 55 from interfering with various kinds of work, the mounting-related process, and the like performed on each mounting line 10 by starting the traveling of AGV 55 before the departure time.

In addition, in a case where the retrieval of feeders 24 in storage chamber 16 is not completed even when the departure time is reached, since a start of traveling of AGV 55 is delayed, it is possible to suppress the possibility of an increase of interference as a result of a long waiting time for AGV 55 at or near storage chamber 16, for example.

In addition, since the traveling of AGV 55 is started when the delay time from the departure time exceeds a predetermined time, it is possible to suppress the occurrence of a large delay in the subsequent schedule (not illustrated, but scheduled after time t3 in Fig. 6) in travel plan TP by an increase of the delay of the departure, thereby suppressing the influence exerted on the conveyance and the retrieval of feeders 24.

It is needless to say that the present disclosure is not limited to the embodiments described above, and various forms can be implemented within the technical scope of the present disclosure.

For example, in the embodiment described above, conveyance control device 58 determines whether AGV 55 arrives at retreat confirmation position P2 based on the position information of AGV 55 in S250; however, the configuration is not limited to this, and the arrival timing to retreat confirmation position P2 may be predicted from the traveling speed of AGV 55, the distance to retreat confirmation position P2, and the like, and it may be determined whether the arrival timing is reached in S250. That is, conveyance control device 58 may confirm the retreat of loader 18 in a case where the arrival timing at which the arrival at retreat confirmation position P2 is predicted is reached.

In the embodiment, the traveling of AGV 55 is started when the delay time from the departure time exceeds a predetermined time; however, the configuration is not limited to this, and the traveling of AGV 55 may not be started in a case where the retrieval of feeders 24 is not completed even if the delay time exceeds a predetermined time.

In the embodiment, when the departure time is reached, the traveling of AGV 55 is started after determining whether the state is such that the retrieval of feeders 24 in storage chamber 16 is completed and the retrieval of feeders 24 is possible; however, the configuration is not limited to this. For example, the configuration is not limited to whether the state is such that the retrieval of feeders 24 is possible, and it may confirm whether the state is such that the serving of feeders 24 in storage chamber 16 is possible, or it may confirm both whether the state is such that the retrieval of feeder 24 is possible and the serving of feeders 24 is possible. That is, it is only necessary to determine whether a predetermined condition related to the state of members, such as feeder 24, in storage chamber 16 is satisfied. Alternatively, the traveling of AGV 55 may be started when the departure time is reached without making a determination related to the state of such members.

In addition, the traveling of AGV 55 may be started in consideration of not only the departure time but also the production state of mounting line 10. Fig. 9 is a flowchart illustrating an AGV travel control of a modification example. In the modification example, a part whose process is different from that of Fig. 7 will be mainly described with reference to Fig. 9.

In this modification example, when the departure time is reached in S200, conveyance control device 58 acquires the production state of each mounting line 10 by communication with mounting control device 38 (S202), and determines whether the setup change of each mounting line 10 is completed (S204). For example, conveyance control device 58 determines whether both the setup change of mounting line 10A and the setup change of mounting line 10B illustrated in Fig. 6 are completed. When the setup change is completed, conveyance control device 58 starts the traveling of AGV 55 in S230. In addition, when the setup change is not completed, conveyance control device 58 returns to S202 and waits for the setup change to be completed while acquiring the production state, and starts the traveling of AGV 55 in S230 when the setup change is completed. As described above, in the modification example, even when the departure time is reached, in a case where the setup change is not completed because the production state is behind production plan PP, the traveling start of AGV 55 is delayed. Therefore, since AGV 55 started traveling in a state in which the setup change was not completed, it is possible to surely prevent the traveling of AGV 55 from obstructing the setup change or the traveling of AGV 55 from being obstructed by the setup change.

In addition, even in a case where the departure time is not reached in S200, conveyance control device 58 acquires the production state of each mounting line 10 by communication with mounting control device 38 (S206), and determines whether the setup change of each mounting line 10 is completed (S208). When the setup change is not completed, conveyance control device 58 returns to S200 and waits for the departure time to be reached, and waits for the setup change to be completed while acquiring the production state. In addition, when the setup change is completed even if the departure time is not reached, conveyance control device 58 starts the traveling of AGV 55 in S230. As described above, in the modification example, even before the departure time is reached, in a case where the setup change is completed because the production state is ahead of production plan PP, the traveling start of AGV 55 is advanced. Therefore, since it is possible to quickly start the traveling of AGV 55 as soon as it is in a state where AGV 55 can travel based on the production state, it is possible to efficiently travel AGV 55 and improve the retrieval efficiency of feeder 24.

In the modification example, conveyance control device 58 determines whether the setup change is completed from the production state both after the departure time is reached and before the departure time is reached; however, the configuration is not limited to this. For example, conveyance control device 58 may determine whether the setup change is completed from the production state, either after the departure time is reached or before the departure time is reached, and start the traveling of AGV 55. In addition, in the modification example, conveyance control device 58 determines whether the setup change is completed from the acquired production state, but it is not limited to the setup change, and may determine whether there is a delay with respect to production plan PP from the acquired production state. In such a case, conveyance control device 58 may perform at least one of a control for causing AGV 55 to advance the traveling start in a case where the production state is ahead of production plan PP, and a control for causing AGV 55 to delay the traveling start in a case where the production state is behind production plan PP.

In Fig. 9 of the modification example, S210, S220, and S240 in Fig. 7 are not illustrated and these processes are not performed; however, the configuration is not limited to this, and it may proceed to the process of S210 in the same manner as in the embodiment and the processes of S210, S220, and S240 may be performed. That is, conveyance control device 58 may proceed to the process of S210 in both or one of the cases of determining the completion of the setup change in S204 after the departure time is reached in S200 and determining of the completion of the setup change in S208 before the departure time is reached in S200. For example, it can be said that a possibility that the retrieval is not completed is higher before the departure time than after the departure time. For this reason, in a case where it is determined that the setup change is completed in S208 before the departure time is reached, the process of S210 may proceed, and in a case where it is determined that the setup change is completed in S204 after the departure time is reached, the process of S210 (S220 and S240) may be omitted and the process of S230 may proceed.

In the embodiment, travel plan TP of AGV 55 is created based on the schedule of the setup change of production plan PP; however, the configuration is not limited to this, and travel plan TP of AGV 55 may be created based on production plan PP. In addition, management device 5 creates travel plan TP, but conveyance control device 58 may create travel plan TP. In other words, the creation of travel plan TP and the travel control of AGV 55 are not limited to being performed by separate devices, and may be performed by the same device.

In the embodiment, conveyance control device 58 causes AGV 55 to stand by at retreat confirmation position P2 in a case where the retreat completion of loader 18 cannot be confirmed; however, the configuration is not limited to this, and AGV 55 may be caused to stand by at a position different from retreat confirmation position P2. That is, AGV 55 may be caused to stand by at a position closer to storage chamber 16, which is the destination, than retreat confirmation position P2. Alternatively, regardless of whether the retreat completion of loader 18 can be confirmed, AGV 55 may be caused to temporarily stop at retreat confirmation position P2, and in a case where the retreat completion of loader 18 cannot be confirmed, AGV 55 may be caused to stand by as it is, whereas in a case where the retreat completion of loader 18 can be confirmed, AGV 55 may be caused to travel again.

In the embodiment, members, such as feeder 24, used in the mounting-related process are conveyed to dedicated storage chamber 16 in mounting line 10 by AGV 55; however, the configuration is not limited to this, and the members may be conveyed to a predetermined portion in mounting line 10. For example, the member may be conveyed to a storage chamber provided in each device (such as print device 12, print device 14, mounter 20, or mounting inspection device 28), such as a storage chamber provided below mounter 20 of Fig. 3.

Here, the mounting system in the present disclosure may be configured as follows. In the following description, the mounting system is not limited to one based on a production plan of multiple mounting lines, and may be based on a production plan of one mounting line, such as a mounting line including a destination (predetermined portion) of an automatic conveyance vehicle, for example, and the mounting system is not limited to one including multiple mounting lines. For example, the mounting system of the present disclosure may be configured to create the travel plan based on a schedule of a setup change of the mounting-related device in the production plan so that the setup change does not obstruct the traveling of the automatic conveyance vehicle, or so that the traveling of the automatic conveyance vehicle does not obstruct the setup change. In this way, it is possible to prevent the automatic conveyance vehicle from interfering with the setup change work performed on each mounting line. In addition, this configuration is not limited to multiple mounting lines, and may be a setup change of one mounting line or a setup change of multiple mounting-related devices of one mounting line.

In the mounting system of the present disclosure, the control section may be configured to, without starting traveling to the predetermined portion until a departure time determined by the travel plan is reached, cause the automatic conveyance vehicle to start the traveling to the predetermined portion when the departure time is reached. As a result, it is possible to prevent the automatic conveyance vehicle from interfering with various kinds of work, the mounting-related process, and the like of each mounting line by causing the automatic conveyance vehicle to depart before the departure time.

In the mounting system of the present disclosure, the control section may be configured to acquire a state of the member at the predetermined portion and, in a case where a predetermined condition related to the state of the member at the predetermined portion is not satisfied even when the departure time is reached, cause the automatic conveyance vehicle to delay a start of the traveling to the predetermined portion. In this way, it is possible to suppress the possibility of an increase of interference as a result of a long waiting time for the automatic conveyance vehicle by waiting for a predetermined condition to be satisfied at or near a predetermined portion.

In the mounting system of the present disclosure, the control section may be configured to cause the automatic conveyance vehicle to start the traveling to the predetermined portion when a delay from the departure time exceeds a predetermined time even in a case where the predetermined condition is not satisfied. In this way, it is possible to suppress the occurrence of a large delay in the subsequent schedule in the travel plan by an increase of the delay of the departure. Therefore, it is possible to suppress the influence exerted on the automatic conveyance of the member.

In the mounting system of the present disclosure, the control section may be configured to acquire a state of production in the multiple mounting lines, and perform at least one of a control for causing the automatic conveyance vehicle to advance a traveling start than a departure time determined by the travel plan in a case where the state of the production is ahead of the production plan, and a control for causing the automatic conveyance vehicle to delay a traveling start from the departure time in a case where the state of the production is behind the production plan. In this way, since it is possible to start the traveling of the automatic conveyance vehicle at an appropriate timing according to the state of production, the automatic conveyance vehicle can be traveled more efficiently.

### Industrial Applicability

The present disclosure can be used in a mounting system or the like in which a member is conveyed by an automatic conveyance vehicle.

### Reference Signs List

1: mounting system, 5: management device, 5a: CPU, 5b: ROM, 5c: RAM, 5d: HDD, 10, 10A, 10B: mounting line, 12: print device, 14: print inspection device, 16: storage chamber, 16a: first storage section, 16b: second storage section, 18: loader, 20: mounter, 22: mounting unit, 24: feeder, 28: mounting inspection device, 30: reflow device, 32: reflow inspection device, 38: mounting control device, 50: conveyance system, 55: automatic conveyance vehicle (AGV), 55a: magazine, 57: charging station, 58: conveyance control device, 60: warehouse, M: worker, PP: production plan, S: board, TP: travel plan

## Claims

1. A mounting system including multiple mounting lines in which multiple mounting-related devices configured to perform a mounting-related process related to mounting a component are arranged side by side, the mounting system in which a member used in the mounting-related process is conveyed to a predetermined portion in the mounting line by an automatic conveyance vehicle, the mounting system comprising:
a creation section configured to create a travel plan of the automatic conveyance vehicle based on a production plan of the multiple mounting lines; and
a control section configured to control traveling of the automatic conveyance vehicle to the predetermined portion based on the travel plan.

2. The mounting system according to claim 1, wherein the creation section is configured to create the travel plan based on a schedule of a setup change of the mounting-related device in the production plan so that the setup change does not obstruct the traveling of the automatic conveyance vehicle, or so that the traveling of the automatic conveyance vehicle does not obstruct the setup change.

3. The mounting system according to claim 1 or 2, wherein the control section is configured to, without starting traveling to the predetermined portion until a departure time determined by the travel plan is reached, cause the automatic conveyance vehicle to start the traveling to the predetermined portion when the departure time is reached.

4. The mounting system according to claim 3, wherein the control section is configured to acquire a state of the member at the predetermined portion, and in a case where a predetermined condition related to the state of the member at the predetermined portion is not satisfied even when the departure time is reached, cause the automatic conveyance vehicle to delay a start of the traveling to the predetermined portion.

5. The mounting system according to claim 4, wherein the control section is configured to cause the automatic conveyance vehicle to start the traveling to the predetermined portion when a delay from the departure time exceeds a predetermined time even in a case where the predetermined condition is not satisfied.

6. The mounting system according to any one of claims 1 to 5, wherein the control section is configured to acquire a state of production in the multiple mounting lines, and perform at least one of a control for causing the automatic conveyance vehicle to advance a traveling start than a departure time determined by the travel plan in a case where the state of the production is ahead of the production plan, and a control for causing the automatic conveyance vehicle to delay a traveling start from the departure time in a case where the state of the production is behind the production plan.
